# EUROPEAN PATENT APPLICATION

(11) **EP 4 637 294 A1**
(43) Date of publication of application: **22.10.2025**
(21) Application number: 25164053.8
(22) Date of filing: 17.03.2025
(51) Int. Cl.: H10D 30/01, H10D 30/66, H10D 62/10, H10D 62/13

(54) **POWER SEMICONDUCTOR DEVICE AND POWER CONVERTER INCLUDING THE SAME, AND MANUFACTURING METHOD OF POWER SEMICONDUCTOR DEVICE**

(30) Priority: 19.04.2024 KR 20240052451
(71) Applicant: LX Semicon Co., Ltd., Daejeon 34027 (KR)
(72) Inventor: LEE, Ho Jung, Daejeon 34027 (KR); KANG, Nam Ju, Daejeon 34027 (KR)
(74) Representative: Ter Meer Steinmeister & Partner

(57) **Abstract**

The embodiment relates to a power semiconductor device, a power semiconductor module, a power convertor, and a method of manufacturing the same.

The power semiconductor device according to the embodiment may include a substrate, a first epitaxial layer of a first conductivity type disposed on the substrate, a second-first epitaxial layer of a first conductivity type disposed on the first epitaxial layer of the first conductivity type, a second-second epitaxial layer of a first conductivity type disposed on the second-first epitaxial layer of the first conductivity type, a well of the second conductivity type partially disposed in the second-first epitaxial layer of the first conductivity type, an ion implantation region and a source region of a second conductivity type located above the well of the second conductivity type, a source electrode disposed on the source region, a gate insulating layer disposed in a trench region in which a portion of the ion implantation region of the second conductivity type and the second-second epitaxial layer of the first conductivity type are removed, a trench gate disposed on the gate insulating layer, an interlayer insulating layer disposed on the trench gate and a gate electrode electrically connected to the trench gate.

## Description

### BACKGROUND OF THE DISCLOSURE

### 1. Field of the Disclosure

The embodiment relates to a power semiconductor device, a power semiconductor module, a power convertor, and a method of manufacturing the same.

### 2. Background of the Related Art

Power semiconductor is one of the key elements that determines the efficiency, speed, durability, and reliability of power electronic systems.

With the recent development of the power electronics industry, the previously used silicon (Si) power semiconductors have reached their physical limits, research is being actively conducted on WBG (wide bandgap) power semiconductors such as silicon carbide (SiC) and gallium nitride (GaN) power semiconductor to replace the Si power semiconductor.

WBG power semiconductor devices have a band gap energy that is approximately three times than that of Si power semiconductor devices, due to this, it has the characteristics of low intrinsic carrier concentration, high breakdown electric field (about 4 to 20 times), high thermal conductivity (about 3 to 13 times), and large electron saturation rate (about 2 to 2.5 times) comparing the Si power semiconductor.

Since these characteristics enable operation in high temperature and high voltage environments, the WBG power semiconductor devices have high switching speed and low switching loss. Among these, gallium nitride (GaN) power semiconductor devices may be used in low-voltage systems, and silicon carbide (SiC) power semiconductor devices may be suitable for high-voltage systems.

SiC MOSFET power semiconductors in the prior art generally have a vertical diffused structure and are referred to as VDMOSFETs, and also may be referred to simply as double-diffused structure DMOSFETs. Additionally, SiC MOSFETs may be classified into Planar MOSFETs and Trench MOSFETs depending on the direction of the channel.

Among these, Trench MOSFET is a structure in which a channel is formed on the sidewall of the trench. For this, a gate insulating film is formed on the sidewall of the trench and a gate electrode is formed in the trench.

Since SiC MOSFETs have high R_{ON} due to low channel mobility and large channel resistance, trench MOSFETs were proposed to reduce R_{ON}. Trench MOSFET has the advantage of increasing channel density by forming channels on the sidewalls of the trench.

However, because trench MOSFET has a larger electric field in trench gate oxide which has a shorter drift distance than P-base (P-well) and the electric field is concentrated at the edge of the trench, there is a problem that gate oxide breakdown occurs quickly and BV (Breakdown voltage) decreases.

For example, the breakdown field strength of SiC Trench MOSFET is 10 times that of Si MOSFET, so SiC semiconductor devices are used with a voltage close to 10 times that of Si devices. For this reason, an electric field 10 times stronger than that of the silicon device is applied to the gate insulating film formed in the trench, there is a problem that the gate insulating film is easily destroyed at the corners of the trench.

Internal technology is researching a process to form a p-type well (P-base) deeper than the gate trench to prevent electric field concentration at the corner of the trench, but in order to form such a deep p-type well, there is a problem that ion implantation energy exceeds the level of a general process.

In addition, since high-energy ion implantation causes severe ion implantation outside a target area, there is a problem of cell pitch reduction due to difficulty in controlling lateral straggling.

### SUMMARY OF THE DISCLOSURE

One of the technical objects of the power semiconductor device, the power convertor including the same, and the manufacturing method of the power semiconductor device according to the embodiment is to prevent electric field concentration at the corners of the trench and prevent the problem of cell pitch reduction due to lateral straggling.

The technical problems of the embodiments are not limited to those described in this item and include those that may be understood through the description of the invention.
The object is solved by the features of the independent claims. Preferred embodiments are given in the dependent claims.

A power semiconductor device according to an embodiment may include a substrate, a first epitaxial layer of a first conductivity type disposed on the substrate, a second epitaxial layer of the first conductivity type disposed on the first epitaxial layer of the first conductivity type, a well of the second conductivity type partially formed in the second epitaxial layer of the first conductivity type, an ion implantation region of the second conductivity type and a source region located above the well of the second conductivity type, a source electrode disposed on the source region, a gate insulating layer formed in a trench region in which a portion of the ion implantation region of the second conductivity type and the second epitaxial layer of the first conductivity type are removed, a trench gate disposed on the gate insulating layer, an interlayer insulating layer disposed on the trench gate, and a gate electrode electrically connected to the trench gate.

The second epitaxial layer of the first conductivity type may include a second-first epitaxial layer of the first conductivity type disposed on the first epitaxial layer of the first conductivity type, and a second-second epitaxial layer of the first conductivity type disposed on the second-first epitaxial layer of the first conductivity type.

The well of the second conductivity type may be partially formed in the second epitaxial layer of the first conductivity type.

An upper surface of the well of the second conductivity type may be equal to or lower than the second-first epitaxial layer of the first conductivity type.
A doping concentration of the well of the second conductivity type in the second-first epitaxial layer of the first conductivity type may be higher than a doping concentration of the ion implantation region of the second conductivity type.

The gate insulating layer may be in contact with the upper surface of the well of the second conductivity type.

The trench gate may be arranged to be vertically aligned with the well of the second conductivity type.

The well of the second conductivity type may be placed lower than the trench gate.

A power semiconductor device according to an embodiment may include a substrate 110, a first epitaxial layer of the first conductivity type 111 disposed on the substrate 110, a second-first epitaxial layer of the first conductivity type 112a disposed on the first epitaxial layer of the first conductivity type 111, a second-second epitaxial layer of the first conductivity type 112b disposed on the second-first epitaxial layer of the first conductivity type 112a, a well 121 of a second conductivity type partially formed in the second-first epitaxial layer of the first conductivity type 112a, an ion implantation region of the second conductivity type 122 and a source region 115 located above the well of the second conductivity type 121, and a source electrode 142 disposed on the source region 115, a gate insulating layer 131 in which a trench region T is formed in which a portion of the ion implantation region 122 of the second conductivity type and the second-second epitaxial layer of the first conductivity type 112b are removed, a trench gate 132 disposed on the gate insulating layer 131, an interlayer insulating layer 150 disposed on the trench gate 132, and a gate electrode electrically connected to the trench gate 132.

The upper surface of the well of the second conductivity type 121 may be equal to or lower than the second-first epitaxial layer of the first conductivity type 112a.

The doping concentration of the well of the second conductivity type 121 formed in the second-first epitaxial layer of the first conductivity type 112a may be higher than the doping concentration of the ion implantation region 122 of the second conductivity type.

The power convertor according to the embodiment may include any of the above power semiconductor devices.

The method of manufacturing a power semiconductor device according to an embodiment may include growing a first epitaxial layer of the first conductivity type 111 on a substrate 110, growing a second-first epitaxial layer of a first conductivity type 112a on the first epitaxial layer of the first conductivity type 111, partially forming a well 121 of a second conductivity type by implanting ions into the second-first epitaxial layer of the first conductivity type 112a, growing a second-second epitaxial layer 112b of a first conductivity type on the second-first epitaxial layer of the first conductivity type 112a, forming an ion implantation region 122 of a second conductivity type and a source region 115 by implanting ions into the second-second epitaxial layer of the first conductivity type 112b, forming a trench region T by removing a portion of the ion implantation region 122 of the second conductivity type and the second-second epitaxial layer of the first conductivity type 112b, forming a gate insulating layer 131 and a trench gate 132 in the trench region, forming an interlayer insulating layer 150 on the trench gate 132 and forming a gate electrode electrically connected to the trench gate 132.

The upper surface of the well of the second conductivity type 121 may be equal to or lower than the second-first epitaxial layer of the first conductivity type 112a.

The doping concentration of the well of the second conductivity type 121 formed in the second-first epitaxial layer of the first conductivity type 112a may be higher than the doping concentration of the ion implantation region 122 of the second conductivity type.

In the step of forming the trench region T by removing a portion of the ion implantation region 122 of the second conductivity type and the second-second epitaxial layer of the first conductivity type 112b, a portion of the well of the second conductivity type 121 may be exposed.

The gate insulating layer 131 may contact the well of the second conductivity type 121.

The hard mask pattern for forming the trench region may correspond to an open area of the hard mask pattern for ion implantation to form the well of the second conductivity type 121.

The trench region may be arranged to be vertically aligned with the well of the second conductivity type 121.

The trench gate 132 and the well of the second conductivity type 121 may be vertically aligned.

### EFFECTS OF THE DISCLOSURE

According to the power semiconductor device, the power convertor including the same, and the manufacturing method of the power semiconductor device according to the embodiment, the well of the second conductivity type 121 may be disposed below the trench gate 132 to disperse the electric field concentrated at the bottom corner of the trench gate. If the electric field of the bottom corner of the trench gate is not dispersed, the breakdown voltage may decrease significantly or problems with gate reliability may occur, which may reduce the life of the semiconductor device.

Also, according to an embodiment, since the well of the second conductivity type 121 may be formed without using high-energy ion implantation, the embodiment can prevent the problem of pitch reduction due to lateral straggling of the dopant and can form the well of the second conductivity type 121 in a region deeper than the trench at the same time. So, there is a technical effect of preventing destruction of the gate insulating layer by dispersing the electric field concentrated at the gate trench bottom corner.

In addition, the doping concentration of the well of the second conductivity type 121 formed on the second-first epitaxial layer of the first conductivity type 112a in the embodiment may be higher than that of the ion implantation region of the second conductivity type 122. For example, according to the embodiment, there is a technical effect of being able to implement a concentration gradient in which the doping concentration of the well of the second conductivity type 121 formed below the trench gate 132 changes more abruptly than the doping concentration of the ion implantation region of the second conductivity type 122 formed adjacent to the trench gate 132.

For example, the doping concentration of the well of the second conductivity type 121 may be 2×10¹⁷~2×10¹⁹/m³, and the doping concentration of the ion implantation region of the second conductivity type 122 may be 1×10¹⁶ to 1×10¹⁷/cm³, but is not limited thereto.

According to the embodiment, as the doping concentration of the well of the second conductivity type 121 formed below the trench gate 132 is formed to be higher than the doping concentration of the ion implantation region of the second conductivity type 122, the depletion layer can be expanded in the direction of the substrate 110. So, there is a technical effect of increasing the breakdown voltage. In addition, according to the embodiment, as the doping concentration of the ion implantation region of the second conductivity type 122 formed around the trench gate 132 is formed to be lower than the doping concentration of the well of the second conductivity type 121, there is a complex technical effect of reducing the threshold voltage and increasing current density.

The technical effects of the embodiments are not limited to those described in this item and can include those that may be understood through the description of the invention.

### BRIEF DESCRIPTION OF THE DRAWINGS

FIG. 1 is an exemplary configuration diagram of a power convertor 1000 of an embodiment.
FIG. 2 is a cross-sectional view of a power semiconductor device 100 of an embodiment.
FIG. 3 is a cross-sectional view of a power semiconductor device 100 of an embodiment.
FIGS. 4 to 10 are cross-sectional views of the manufacturing process of the power semiconductor device 100 according to an embodiment.

### DETAILED DESCRIPTION OF THE DISCLOSURE

Hereinafter, the invention according to the embodiment for solving the above problem will be described in more detail with reference to the drawings.

The suffixes "module" and "part" for the components used in the following description are simply given in consideration of the ease of writing this specification, and do not in themselves give any particularly important meaning or role. Accordingly, the terms "module" and "unit" may be used interchangeably.

Terms containing ordinal numbers, such as first, second, etc., may be used to describe various components, but the components are not limited by the terms. The above terms are used only for the purpose of distinguishing one component from another.

Singular expressions include plural expressions, unless the context clearly indicates otherwise.

In this application, terms such as "include," "have," or "equipped with" are intended to specify the presence of features, numbers, steps, operations, components, parts, or combinations thereof described in the specification. The terms should be understood that this does not exclude in advance the presence or addition of one or more other features, numbers, steps, operations, components, parts, or combinations thereof.

### (Embodiment)

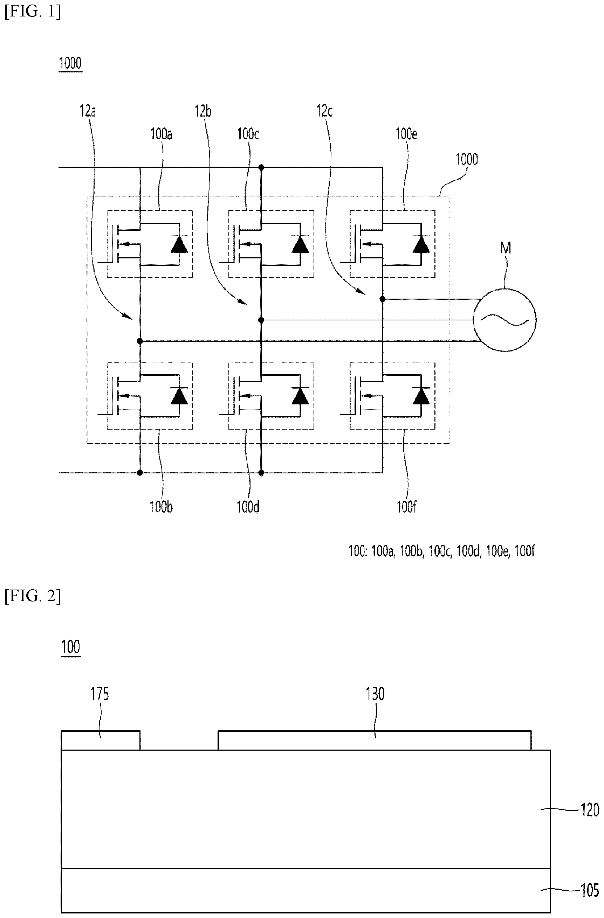

FIG. 1 is an exemplary configuration diagram of a power convertor 1000 according to an embodiment.

The power converter 1000 according to the embodiment may receive DC power from a battery or fuel cell and convert it into AC power, and supply AC power to a predetermined load. For example, the power convertor 1000 according to the embodiment may include an inverter, and may receive DC power from the battery, convert it into three-phase AC power, and supply it to the motor M, and the motor M may provide power to electric vehicles, fuel cell vehicles, etc.

The power convertor 1000 according to the embodiment may include a power semiconductor device 100. The power semiconductor device 100 may be a MOSFET (Metal Oxide Semiconductor Field Effect Transistor), but is not limited thereto, and may include an IGBT (Insulated Gate Bipolar Transistor).

For example, the power convertor 1000 may include a plurality of power semiconductor devices 100a, 100b, 100c, 100d, 100e, 100f and a plurality of diodes (not shown). Each of the plurality of diodes may be embedded in each of the power semiconductor devices 100a, 100b, 100c, 100d, 100e, and 100f in the form of an internal diode, but is not limited thereto, and may be disposed separately.

The embodiment may convert DC power to AC power through on-off control of a plurality of power semiconductor devices 100a to 100f. For example, the power convertor 1000 according to the embodiment turns on the first power semiconductor device 100a and turns off the second power semiconductor device 100b in the first time period of one cycle to supply positive polarity power to the motor M, and may supply negative polarity power to the motor M by turning off the first power semiconductor device 100a and turning on the second power semiconductor device 100b in the second time period of one cycle.

In the embodiment, a group of power semiconductor devices arranged in series on the high-voltage line and low-voltage line on the input side may be called an arm. For example, the first power semiconductor device 100a and the second power semiconductor device 100b constitute the first arm 12a, and the third power semiconductor device 100c and the fourth power semiconductor device 100d form the second arm 12b, and the fifth power semiconductor device 100e and the sixth power semiconductor device 100f may form a third arm 12c.

In the arm, the upper power semiconductor device and the lower power semiconductor device may be controlled not to be turned on at the same time. For example, in the first arm, the first power semiconductor device 100a and the second power semiconductor device 100b may not be turned on at the same time but may be alternately turned on and off.

Each power semiconductor device 100a to 100f may receive high power in an off state. For example, if the second power semiconductor device 100b is turned off while the first power semiconductor device 100a is turned on, the input voltage may be applied to the second power semiconductor device 100b as is. The voltage input to the second power semiconductor device 100b may be a relatively high voltage, and the withstand voltage of each power semiconductor device 100a to 100f may be designed to a high level to withstand this high voltage.

Each power semiconductor device 100a~100f may conduct high current in the on state. The motor M is driven with a relatively high current, and this high current may be supplied to the motor M through a power semiconductor that is turned on.

High voltage applied to each power semiconductor device 100a~100f may cause high switching loss. High current conducting power semiconductor devices 100a~100f may cause high conduction loss. In order to dissipate the heat generated by such loss, the power semiconductor devices 100a to 100f may be packaged as a power semiconductor module including a heat dissipation means.

The power semiconductor device 100 of the embodiment may be a silicon carbide (SiC) power semiconductor device, may operate in a high temperature and high voltage environment, and may have high switching speed and low switching loss.

Meanwhile, the power convertor 1000 according to the embodiment may include a plurality of power semiconductor modules.

For example, a plurality of power semiconductor devices 100a to 100f shown in FIG. 1 may be packaged into one power semiconductor module, or the power semiconductor devices constituting each arm may be packaged into one power semiconductor module.

For example, the first power semiconductor device 100a, the second power semiconductor device 100b, the third power semiconductor device 100c, the fourth power semiconductor device 100d, the fifth power semiconductor device 100e and the sixth power semiconductor device 100f shown in FIG. 1 may be packaged as one power semiconductor module.

Additionally, there may be additional power semiconductor devices placed in parallel with each power semiconductor device 100a to 100f to increase current capacity. **In** this case, the number of power semiconductor devices included in the power semiconductor module may be more than six.

The power convertor 1000 according to the embodiment may also include diode-type power semiconductor devices in addition to the transistor-type power semiconductor devices 100a to 100f. For example, a first diode (not shown) may be disposed in parallel with the first power semiconductor device 100a, and a second diode (not shown) may be disposed in parallel with the second power semiconductor device 100b. And, these diodes may also be packaged together in one power semiconductor module. Additionally, the diode may be disposed in the form of an internal diode in each power semiconductor device.

Next, the power semiconductor devices that make up each arm may be packaged into one power semiconductor module.

For example, the first power semiconductor device 100a and the second power semiconductor device 100b constituting the first arm may be packaged into a first power semiconductor module, the third power semiconductor device 100c and the fourth power semiconductor device 100d constituting the second arm may package into a second power semiconductor module, and the fifth power semiconductor device 100e and the sixth power semiconductor device 100f constituting the third arm may be packaged as a third power semiconductor module.

Additionally, in order to increase current capacity, there may be additional power semiconductor devices placed in parallel with each power semiconductor device 100a~100f. In this case, the number of power semiconductor devices included in each power semiconductor module is two, but there may be more. In addition, each arm may include diode-type power semiconductor devices (not shown) in addition to transistor-type power semiconductor devices 100a to 100f, and these diodes may also be packaged together in one power semiconductor module. Additionally, the diode may be disposed in the form of an internal diode in each power semiconductor device.

Next, FIG. 2 is a cross-sectional view of one of the power semiconductor devices 100 according to an embodiment.

The power semiconductor device 100 according to the embodiment may include a source electrode 130, a gate electrode 175 disposed above a predetermined semiconductor epitaxial layer 120, and a drain electrode 105 disposed below the semiconductor epitaxial layer 120.

In the form of a MOSFET, the source electrode 130 or the gate electrode 175 may include an Al-based metal. And the drain electrode 105 may be a Ti/Ni/Ag layer including a Ti layer, a Ni layer, and an Ag layer, and may include metal, NiV/Ag, V(vanadium)/Ni/Ag, etc., but is not limited thereto.

One of the technical objects of the embodiment is to prevent electric field concentration at the corner of the trench and prevent the problem of cell pitch reduction due to lateral straggling.

Hereinafter, the power semiconductor device 100 according to an embodiment for solving the above technical problems will be described.

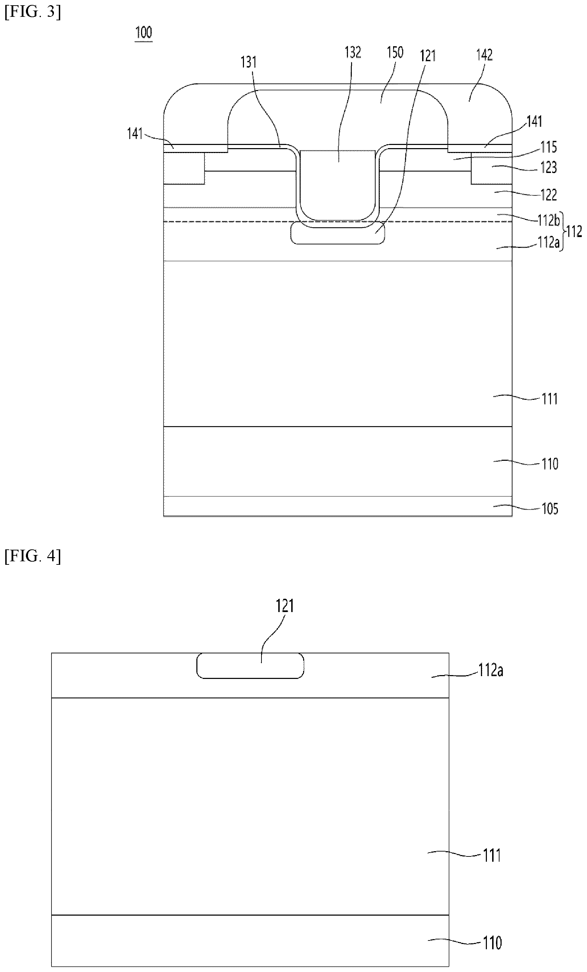

FIG. 3 is a cross-sectional view of a power semiconductor device 100 according to an embodiment.

First, referring to FIG. 3, the power semiconductor device 100 according to the embodiment may include at least one of a drain electrode 105, a substrate 110, a first epitaxial layer of the first conductivity type 111, a second epitaxial layer 112 of a first conductivity type, a well of the second conductivity type 121, a ion implantation region of the second conductivity type 122, a source area of the first conductivity type 115, a source contact 141, a contact region of the second conductivity type 123, a source electrode 142, a gate insulating layer 131, a gate 132, and an interlayer insulating layer 150.

The second epitaxial layer of the first conductivity type 112 may include a second-first epitaxial layer of the first conductivity type 112a and a second-second epitaxial layer of the first conductivity type 112b.

The first conductivity type may be N-type, and the second conductivity type may be P-type, but are not limited thereto. The substrate 110, the first epitaxial layer of the first conductivity type 111, and the second epitaxial layer of the first conductivity type 112 may include a SiC (Silicon Carbide), but are not limited thereto.

Specifically, the power semiconductor device 100 according to the embodiment may include a substrate 110, a first epitaxial layer of the first conductivity type 111 disposed on the substrate 110, a second-first epitaxial layer of a first conductivity type 112a disposed on the first epitaxial layer of the first conductivity type 111, and a second-second epitaxial layer of the first conductivity type 112b disposed on the second-first epitaxial layer of the first conductivity type 112a.

Additionally, the embodiment may include a well of the second conductivity type 121 formed in the second-first epitaxial layer of the first conductivity type 112a.

The upper surface of the well of the second conductivity type 121 may be equal to or lower than the second-first epitaxial layer of the first conductivity type 112a.

In addition, the embodiment may include a ion implantation region of the second conductivity type 122 located above the well of the second conductivity type 121, and a source region 115 and a contact region of the second conductivity type 123 disposed on the ion implantation region of the second conductivity type 122.

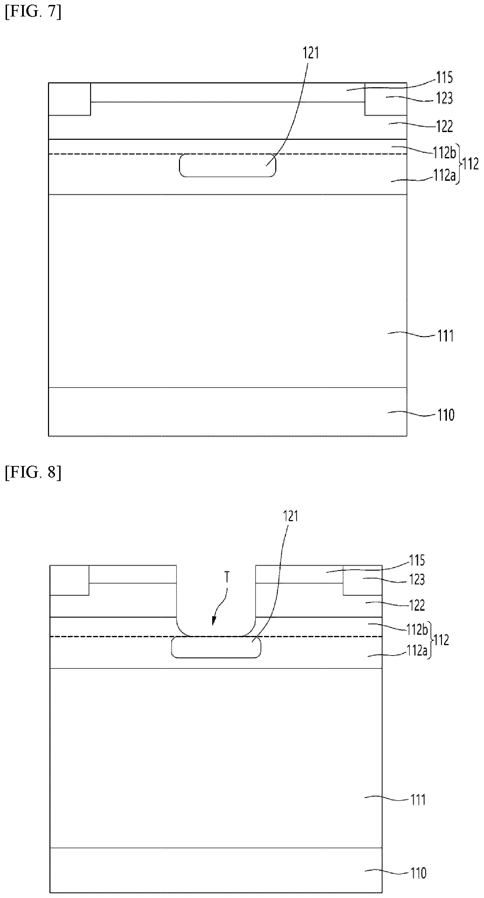

In addition, the embodiment may include a source electrode 142 disposed on the source region 115 and the contact region of the second conductivity type 123, a gate insulating layer 131 formed on the bottom and sidewalls of the trench region T (see FIG. 8) from which a portion of the ion implantation region of the second conductivity type 122 and the first conductivity type second-second epitaxial layer 112b is removed. a trench gate 132 disposed on the gate insulating layer 131, an interlayer insulating layer 150 disposed on the trench gate 132, and a gate electrode (not shown) electrically connected to the trench gate 132.

According to the power semiconductor device, the power convertor including the same, and the manufacturing method of the power semiconductor device according to the embodiment, the well of the second conductivity type 121 may be disposed below the trench gate 132 to disperse the electric field concentrated at the bottom corner of the trench gate. If the electric field at the bottom corner of the trench gate is not dispersed, the breakdown voltage may decrease significantly or problems with gate reliability may occur, which may reduce the life of the semiconductor device.

Also, according to an embodiment, as the well of the second conductivity type 121 may be formed without using high-energy ion implantation, thereby preventing the problem of pitch reduction due to lateral straggling of the dopant and at the same time forming the well of the second conductivity type 121 in a region deeper than the trench, there is a technical effect of preventing destruction of the gate insulating layer by dispersing the electric field concentrated at the gate trench bottom corner.

On the other hand, in the prior art, a high-energy ion implantation was required the introduction of high-cost special equipment, and despite such special equipment, the yield was poor. Also, there is a problem of pitch reduction due to difficulty in lateral straggling control that occurs severely in high-energy ion implantation.

The lateral straggling may refer to an unintentional increase in ion implantation in the lateral direction, and when lateral straggling occurs, there is a problem that Ron increases as the movement width of electrons narrows.

Also, in the prior art, if a subsequent thermal oxidation process is performed on the trench sidewall after ion implantation into the trench sidewall, there is a possibility that unexpectedly grown oxide has occurred in terms of thickness and characteristics, which may affect Vth, Ron, gate oxide life, etc.

In addition, the doping concentration of the well of the second conductivity type 121 formed on the second-first epitaxial layer of the first conductivity type 112a in the embodiment may be higher than that of the ion implantation region of the second conductivity type 122. For example, according to the embodiment, there is a technical effect that it is possible to implement a concentration gradient in which the doping concentration of the well of the second conductivity type 121 formed below the trench gate 132 changes more abruptly than the doping concentration of the ion implantation region of the second conductivity type 122 formed adjacent to the trench gate 132.

For example, the doping concentration of the well of the second conductivity type 121 may be 2×10¹⁷ to 2×10¹⁹/cm³, and the doping concentration of the ion implantation region of the second conductivity type 122 may be 1×10¹⁶ to 1×10¹⁷/cm³, but is not limited to this.

According to the embodiment, as the doping concentration of the well of the second conductivity type 121 formed below the trench gate 132 can be formed to be higher than the doping concentration of the ion implantation region of the second conductivity type 122, the depletion layer can be expanded in the direction of the substrate 110. So, there is a technical effect of increasing the breakdown voltage. In addition, according to the embodiment, the doping concentration of the ion implantation region of the second conductivity type 122 formed around the trench gate 132 may be formed to be lower than the doping concentration of the well of the second conductivity type 121, there is a complex technical effect of reducing the threshold voltage and increasing current density.

Hereinafter, the manufacturing process of the power semiconductor device 100 according to the embodiment shown in FIG. 3 will be described with reference to FIGS. 4 to 10.

First, referring to FIG. 4, the first epitaxial layer of the first conductivity type 111 and the second-first epitaxial layer of the first conductivity type 112a may be sequentially grown on the substrate 110. The first epitaxial layer of the first conductivity type 111 may include a first conductivity type buffer layer (not shown) and a first conductivity type drift layer (not shown).

The substrate 110, the first epitaxial layer of the first conductivity type 111, and the second-first epitaxial layer 112a may include a 4H-SiC material, but are not limited thereto. For example, the substrate 110, the first epitaxial layer of the first conductivity type 111, and the second-first epitaxial layer 112a may include 3C-SiC or 6H-SiC.

Next, the well of the second conductivity type 121 may be formed in the second-first epitaxial layer of the first conductivity type 112a by ion implantation.

For example, the well of the second conductivity type 121 may be formed by forming a first hard mask pattern (not shown) and ion implanting the first hard mask pattern using an ion implantation mask. The well of the second conductivity type 121 may be a P-type body, but is not limited thereto. The first hard mask pattern may include a polysilicon pattern and an oxide pattern, but is not limited thereto.

A P-type dopant may be ion-implanted into the well of the second conductivity type 121. For example, Al or boron may be injected, but it is not limited thereto.

According to the embodiment, by forming the well of the second conductivity type 121 in the second-first epitaxial layer of the first conductivity type 112a without using high-energy ion implantation, thereby preventing the problem of pitch reduction due to lateral straggling of the dopant and at the same time forming the well of the second conductivity type 121 in an area deeper than the trench. So, there is a technical effect of preventing destruction of the gate insulating layer by dispersing the electric field concentrated at the gate trench bottom corner.

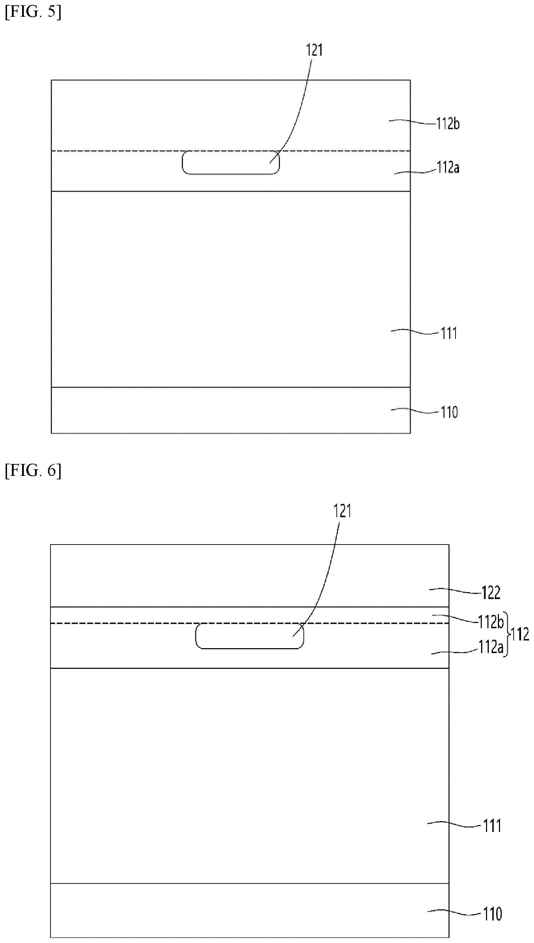

Next, referring to FIG. 5, the second-second epitaxial layer of the first conductivity type 112b may be regrown on the second-first epitaxial layer of the first conductivity type 112a.

According to an embodiment, the well of the second conductivity type 121 is formed on the second-first epitaxial layer of the first conductivity type 112a without using high-energy ion implantation, it is possible to prevent the problem of pitch reduction due to lateral straggling of the dopant and at the same time form the well of the second conductivity type 121 in a region deeper than the trench gate 132 to be formed later. Accordingly, it is possible to disperse the electric field concentrated at the gate trench bottom corner, so there is a technical effect of preventing destruction of the gate insulating layer.

Next, referring to FIG. 6, Al or boron, etc. may be ion-implanted into the second-second epitaxial layer of the first conductivity type 112b to form the ion implantation region of the second conductivity type 122.

The doping concentration of the well of the second conductivity type 121 formed in the second-first epitaxial layer of the first conductivity type 112a of the embodiment may be higher than the doping concentration of the ion implantation region 122 of the second conductivity type.

For example, according to an embodiment, there is a technical effect that it is possible to implement a concentration gradient in which the doping concentration of the well of the second conductivity type 121 to be formed below the trench gate 132 may change abruptly than the doping concentration of the ion implantation region of the second conductivity type 122 to be formed adjacent to the trench gate 132.

For example, the doping concentration of the well of the second conductivity type 121 may be 2×10¹⁷ to 2×10¹⁹/cm³, and the doping concentration of the ion implantation region of the second conductivity type 122 may be 1×10¹⁶ to 1×10¹⁷/cm³, but is not limited to this.

According to the embodiment, because the doping concentration of the well of the second conductivity type 121 to be formed below the trench gate 132 is formed to be higher than the doping concentration of the ion implantation region of the second conductivity type 122, there is a technical effect of expanding the depletion layer in the thereby forming the substrate 110 direction and there is a technical effect of increasing the breakdown voltage.

According to the embodiment, the doping concentration of the ion implantation region of the second conductivity type 122 to be formed around the trench gate 132 is formed lower than the doping concentration of the well 121 of the second conductive type, there is a complex technical effect of reducing the threshold voltage and increasing current density.

Next, referring to FIG. 7, the first conductive type source region 115 may be formed by implanting ions into the second conductive type ion implantation region 122 using an ion implantation mask with a second hard mask pattern (not shown). For example, the first conductivity type source region 115 may be formed by ion implanting an N-type dopant, such as nitrogen or phosphorus, at a concentration of about 1×10¹⁸cm⁻³ to about 7×10¹⁹cm⁻³ using a self-alignment method.

Additionally, the contact region of the second conductivity type 123 may be formed using the third hard mask pattern (not shown) as an ion implantation mask. The contact region of the second conductivity type 123 may function to maintain the zero potential of the ion implantation region of the second conductivity type 122 and may function as a body diode.

Next, referring to FIG. 8, as the fourth hard mask pattern (not shown) may be used as an etch mask, a trench region T may be formed by partially removing the first conductivity type source region 115, the ion implantation region of the second conductivity type 122, and the first conductivity type second-second epitaxial layer 112b.

The fourth hard mask pattern may be an inverted pattern of the first hard mask pattern.

For example, the fourth hard mask pattern for forming the trench region T may correspond to an open area of the first hard mask pattern for ion implantation.

Accordingly, in the embodiment, the trench region T may be formed to be aligned on the well of the second conductivity type 121. Accordingly, the trench gate 132 formed later and the well of the second conductivity type 121 may be vertically aligned.

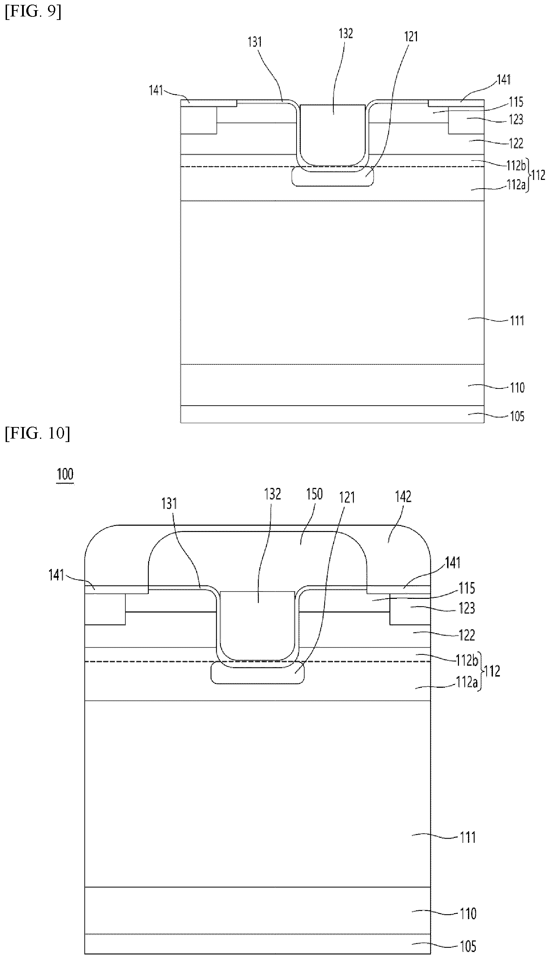

Next, referring to FIG. 9, a gate insulating layer 131 may be formed in the trench region T, and a trench gate 132 may be formed on the gate insulating layer 131.

According to an embodiment, the well of the second conductivity type 121 may be disposed below the trench gate 132 to disperse the electric field concentrated at the bottom corner of the trench gate.

In particular, according to the embodiment, the well of the second conductivity type 121 can be formed without using high-energy ion implantation, it is possible to prevent the problem of pitch reduction due to lateral straggling of the dopant and at the same time to form the well of the second conductivity type 121 in a region deeper than the trench. Accordingly, it is possible to disperse the electric field concentrated at the gate trench bottom corner such that there is a technical effect of preventing destruction of the gate insulating layer.

The gate insulating layer 131 may be a thermal oxide film or an oxide film deposited using LPCVD, etc., but is not limited thereto. The trench gate 132 may be formed of polysilicon, but is not limited thereto.

Afterwards, the source contact 141 may be formed. For example, the source contact 141 may be formed using Ti or Ni, but is not limited thereto.

Additionally, the drain electrode 105 may be formed with Ti/Al on the substrate 110.

Next, referring to FIG. 10, an interlayer insulating layer 150 may be formed on the trench gate 132 and the gate insulating layer 131, and a source electrode 142 and a gate electrode (not shown) may be formed on the interlayer insulating layer 150 and the source contact 141.

The interlayer insulating layer 150 may be formed of an oxide film or a nitride film, but is not limited thereto.

The source electrode 142 may be formed of Al or the like, but is not limited thereto. Additionally, the source electrode 142 may further include a barrier metal layer.

According to the power semiconductor device, the power convertor including the same, and the manufacturing method of the power semiconductor device according to the embodiment, the well of the second conductivity type 121 may be disposed below the trench gate 132 to disperse the electric field concentrated at the bottom corner of the trench gate. If the electric field at the bottom corner of the trench gate is not dispersed, the breakdown voltage may decrease significantly or problems with gate reliability may occur, which may reduce the life of the semiconductor device.

Also, according to an embodiment, the well of the second conductivity type 121 may be formed without using high-energy ion implantation, thereby preventing the problem of pitch reduction due to lateral straggling of the dopant and at the same time forming the well of the second conductivity type 121 in a region deeper than the trench. So, there is a technical effect of preventing destruction of the gate insulating layer by dispersing the electric field concentrated at the gate trench bottom corner.

In addition, the doping concentration of the well of the second conductivity type 121 formed on the second-first epitaxial layer of the first conductivity type 112a in the embodiment may be higher than the doping concentration of the ion implantation region of the second conductivity type 122. For example, according to the embodiment, there is a technical effect that it is possible to implement a concentration gradient in which the doping concentration of the well of the second conductivity type 121 formed below the trench gate 132 changes more abruptly than the doping concentration of the ion implantation region of the second conductivity type 122 formed adjacent to the trench gate 132.

For example, the doping concentration of the well of the second conductivity type 121 may be 2×10¹⁷~2×10¹⁹/m³, and the doping concentration of the ion implantation region of the second conductivity type 122 may be 1×10¹⁶ to 1×10¹⁷/cm³, but is not limited thereto.

According to the embodiment, since the doping concentration of the well of the second conductivity type 121 formed below the trench gate 132 may be formed to be higher than the doping concentration of the ion implantation region of the second conductivity type 122, the depletion layer is expanded in the direction of the substrate 110 such that there is a technical effect of increasing the breakdown voltage. **In** addition, according to the embodiment, as the doping concentration of the ion implantation region of the second conductivity type 122 formed around the trench gate 132 is formed to be lower than the doping concentration of the well of the second conductivity type 121, there is a complex technical effect of reducing the threshold voltage and increasing current density.

**In** the above, the present invention has been described with reference to embodiments, but those skilled in the art will easily understand that various modifications and changes may be made to the present invention without departing from the scope of the present invention as set forth in the claims below.

## Claims

1. A power semiconductor device comprising:
a substrate (110);
a first epitaxial layer (111) of a first conductivity type disposed on the substrate (110);
a second epitaxial layer (112) of the first conductivity type disposed on the first epitaxial layer (111) of the first conductivity type;
a well (121) of a second conductivity type partially disposed in the second epitaxial layer (112) of the first conductivity type;
an ion implantation region (122) of the second conductivity type and a source region (115) disposed above the well (121) of the second conductivity type;
a source electrode (130) disposed on the source region (115);
a gate insulating layer (131) disposed in a trench region (T) in which a portion of the ion implantation region (122) of the second conductivity type and the second epitaxial layer (112) of the first conductivity type are removed;
a trench gate (132) disposed on the gate insulating layer (131);
an interlayer insulating layer (150) disposed on the trench gate (132), and
a gate electrode (175) electrically connected to the trench gate (132).

2. The power semiconductor device according to claim 1, wherein the second epitaxial layer (112) of the first conductivity type comprises a second-first epitaxial layer (112a) of the first conductivity type disposed on the first epitaxial layer (111) of the first conductivity type; and a second-second epitaxial layer (112b) of the first conductivity type disposed on the second-first epitaxial layer (112a) of the first conductivity type.

3. The power semiconductor device according to claim 1 or 2, wherein the well (121) of the second conductivity type is partially disposed in the second epitaxial layer (112) of the first conductivity type.

4. The power semiconductor device according to claim 2 or 3, wherein an upper surface of the well (121) of the second conductivity type is equal to or lower than the second-first epitaxial layer (112a) of the first conductivity type.

5. The power semiconductor device according to claim 2, 3 or 4, wherein a doping concentration of the well (121) of the second conductivity type in the second-first epitaxial layer (112a) of the first conductivity type is higher than a doping concentration of the ion implantation region (122) of the second conductivity type.

6. The power semiconductor device according to any one of the preceding claims, wherein the gate insulating layer (131) is in contact with an upper surface of the well (121) of the second conductivity type.

7. The power semiconductor device according to any one of the preceding claims, wherein the trench gate (132) is arranged to be vertically aligned with the well (121) of the second conductivity type.

8. The power semiconductor device according to any one of the preceding claims, wherein the well (121) of the second conductivity type is disposed lower than the trench gate (132).

9. A power convertor comprising the power semiconductor device according to any one of claims 1 to 8.

10. A manufacturing method of a power semiconductor device comprising:
growing a first epitaxial layer (111) of a first conductivity type on a substrate (110);
growing a second-first epitaxial layer (112a) of the first conductivity type on the first epitaxial layer (111) of the first conductivity type;
partially forming a well (121) of the second conductivity type by implanting ions into the second-first epitaxial layer (112a) of the first conductivity type;
growing a second-second epitaxial layer (112b) of the first conductivity type on the second-first epitaxial layer (112a) of the first conductivity type;
forming an ion implantation region of the second conductivity type and a source region by implanting ions into the second-second epitaxial layer (112b) of the first conductivity type;
forming a trench region (TT) by removing a portion of the ion implantation region (122) of the second conductivity type and the second-second epitaxial layer (112b) of the first conductivity type;
forming a gate insulating layer (131) and a trench gate (132) in the trench region (T);
forming an interlayer insulating layer (150) on the trench gate (132), and
forming a gate electrode (175) electrically connected to the trench gate (132).

11. The manufacturing method of the power semiconductor device according to claim 10, wherein an upper surface of the well (121) of the second conductivity type is equal to or lower than the second-first epitaxial layer (112a) of the first conductivity type.

12. The manufacturing method of the power semiconductor device according to any one of claims 10 and 11, wherein a doping concentration of the well of the second conductivity type formed in the second-first epitaxial layer (112a) of the first conductivity type is higher than a doping concentration of the ion implantation region (122) of the second conductivity type.

13. The manufacturing method of the power semiconductor device according to any one of claims 10 to 12, wherein in the forming the ion implantation region (122) and the source region (115) of the second conductivity type by implanting ions into the second-second epitaxial layer (112b) of the first conductivity type, a portion of the well (121) of the second conductivity type is exposed.

14. The manufacturing method of the power semiconductor device according to any one of claims 10 to 13, wherein the gate insulating layer (131) is configured to contact the well (121) of the second conductivity type.

15. The manufacturing method of the power semiconductor device according to any one of claims 10 to 14, wherein a hard mask pattern for forming the trench region (T) is configured to correspond to an open region of a hard mask pattern for ion implantation to form the well (121) of the second conductivity type.
